# EUROPEAN PATENT SPECIFICATION

(11) **EP 3 267 502 B1**
(45) Date of publication and mention of the grant of the patent: **30.09.2020**
(21) Application number: 17171616.0
(22) Date of filing: 17.05.2017
(51) Int. Cl.: H01L 45/00, H01L 27/24

(54) **MEMORY CELL WITH PARALLEL RESISTIVE MEMORY ELEMENTS**
SPEICHERZELLE MIT PARALLELEN RESISTIVEN SPEICHERELEMENTEN
CELLULE MÉMOIRE AVEC ÉLÉMENTS DE MÉMOIRE RÉSISTIFS PARALLÈLES

(30) Priority: 17.06.2016 US 201615186137
(43) Date of publication of application: 10.01.2018
(73) Proprietor: Altera Corporation, San Jose, California CA 95134-1941 (US)
(72) Inventor: McElheny, Peter John, San Jose, CA California 95134 (US); He, Yue-Song, San Jose, CA California 95134 (US)
(74) Representative: Goddar, Heinz J.

(56) References cited:
- WO-A1-2005/066969
- WO-A1-2010/085241
- US-A1- 2008 128 853
- US-A1- 2009 085 023
- US-A1- 2010 093 130
- US-A1- 2011 220 861
- US-B1- 9 029 829
- PICCOLBONI G ET AL: "Investigation of the potentialities of Vertical Resistive RAM (VRRAM) for neuromorphic applications", IEEE INTERNATIONAL ELECTRON DEVICES MEETING, 7-9 DECEMBER 2015, WASHINGTON, DC, 2015, pages 17.2.1-4, XP032865575, DOI: 10.1109/IEDM.2015.7409717 [retrieved on 2016-02-16]

## Description

### Background

The approaches described in this section could be pursued, but are not necessarily approaches that have been previously conceived or pursued. Therefore, unless otherwise indicated herein, the approaches described in this section are not prior art to the claims in this application and are not admitted to be prior art by inclusion in this section.

Integrated circuits often contain volatile memory elements. Typical volatile memory elements are based on cross-coupled inverters (latches). A volatile memory element retains data only so long as the integrated circuit is powered. In the event of power loss, the data in the volatile memory element is lost. For example, static random-access memory (SRAM) chips contain SRAM cells, which are a type of volatile memory element. Volatile memory elements are also used in programmable logic device integrated circuits.

Volatile memory elements are subject to a phenomenon known as soft error upset. Soft error upset events are caused by cosmic rays and radioactive impurities embedded in integrated circuits and their packages. Cosmic rays and radioactive impurities generate high-energy atomic particles such as neutrons and alpha particles. The memory elements contain transistors and other components that are formed from a patterned silicon substrate. When an atomic particle strikes the silicon in the memory element, electron-hole pairs are generated. The electron-hole pairs create a conduction path that can cause a charged node in the memory element to discharge and the state of the memory element to flip. If, for example, a "1" was stored in the memory element, a soft error upset event could cause the "1" to change to a "0."

It is within this context that the embodiments herein arise.

Piccolboni et al., "Investigation of the potentialities of Vertical Resistive RAM (VRRAM) for neuromorphic applications", IEEE International Electron Devices Meeting (IEDM), December 2015, discusses approaches for combining resistive RAM concept with vertical NAND technology and design as a cost-effective and extensible technology for future mass data storage applications.

US 2010/0093130 A1 provides a method of forming a semiconductor memory cell in which, in order to store two bits or more data in a memory cell, three or more bottom electrode contacts (BECs) and phase-change materials (GST) have a parallel structure on a single contact plug (CP) and set resistances are changed depending on thicknesses (S), lengths (L) or resistivities (p) of the three or more bottom electrode contacts, so that a reset resistance and three different set resistances enable data other than just set and reset states to be stored.

US 2009/0085023 A1 relates to a phase change memory structure. A phase change memory cell has a first electrode, a heater, a phase change material, and a second electrode. The heater is over the first electrode, and the heater comprises a pillar. The phase change material is around the heater. The second electrode is electrically coupled to the phase change material. In some embodiments, a method includes forming a electrode layer over a substrate, depositing a first layer, providing nanoclusters over the first layer, and etching the first layer. The first layer comprises one of a group consisting of a heater material and a phase change material. The first layer may be etched using the nanocluster defined pattern to form pillars from the first layer.

WO 2010/085241 A1 discloses a multilayer memristive device including a first electrode; a second electrode; a first memristive region and a second memristive region which are created by directional ion implantation of dopant ions and are interposed between the first electrode and the second electrode; and mobile dopants which move within the first memristive region and the second memristive region in response to an applied electrical field.

US 9,029,829 B1 shows a memory cell according to the preamble of the independent claim 1, comprising a plurality of resistive switching memory units made of chalcogenide or metal oxide coupled in parallel between top and bottom electrode layers, which is connected to an access device such as a field effect transistor.

US 2011/0220861 A1 relates to a nonvolatile semiconductor memory device which can achieve miniaturization and a larger capacity in a cross-point structure in which memory cells are formed inside contact holes at cross points of word lines and bit lines, respectively.

US 2008/0128853 A1 shows a semiconductor memory device that includes a first conductive line on a semiconductor substrate, an interlayer insulating layer on the first conductive line, a second conductive line on the interlayer insulating layer, and a memory cell in a hole through the interlayer insulating layer wherein the first and second conductive lines cross, the memory cell including a discrete resistive memory material region disposed in the hole and electrically connected between the first and second conductive lines. The resistive memory material region may be substantially contained within the hole.

WO 2005/066969A1 relates to a memory device having variable resistance. A first variable resistor is connected between a first terminal and a third terminal and increases/reduces its resistance value in accordance with the polarity of a pulse voltage applied between the first terminal and the third terminal. A second variable resistor is connected between the third terminal and a second terminal and increases/reduces its resistance value in accordance with the polarity of a pulse voltage applied between the third terminal and the second terminal. Given pulse voltages are applied between the first terminal and the third terminal and between the third terminal and the second terminal to reversibly change the resistance values of the first and second variable resistors, thereby recording one bit or multiple bits of information.

### Summary

The invention is defined by the subject matter of the independent claims. Advantageous embodiments of the invention are subject to the dependent claims. Several embodiments are described below. Embodiments not falling within the scope of one of the independent claims are to be considered examples useful for better understanding this invention.

### Brief Description of the Drawings

FIG. 1 illustrates an exemplary programmable logic device integrated circuit in accordance with an embodiment.
FIG. 2 illustrates a diagram of an exemplary memory array circuitry in accordance with an embodiment.
FIG. 3A illustrates a cross-sectional side view of an exemplary memory cell in accordance with an embodiment.
FIG. 3B illustrates a top view of an exemplary memory cell in accordance with an embodiment.
FIG. 4 illustrates a cross-sectional view of exemplary non-volatile resistive memory elements formed in a memory cell in accordance with an embodiment of the invention.
FIG. 5 illustrates an exemplary method of forming a memory cell in accordance with an embodiment of the present invention.
FIG. 6 illustrates an exemplary graphical representation of the relationship between on-state resistance of a memory cell and a number of non-volatile resistive memory elements in the memory cell in accordance with an embodiment.
FIG. 7 illustrates an exemplary integrated circuit incorporating two memory cells in accordance with an embodiment of the present invention.

### Detailed Description

Non-volatile memory elements can be used to circumvent the shortcomings of traditional volatile memory elements. Non-volatile memory elements can be implemented in a variety of ways in an integrated circuit. For example, resistive memory elements can be implemented. Resistive memory elements come in different varieties based on the process of manufacture and the resistive memory materials utilized during the process of manufacture. Some common types of resistive memory elements include anti-fuse type, ionic-displacement type, and magnetic type. However, non-volatile resistive memory elements usually have a very high SET resistance or on-state resistance. Thus, the resistive memory elements require high current for operation, which may be damaging to the other components of the integrated circuit. Furthermore, memory structures composed of resistive memory elements tend to have large variation across memory cells.

The present embodiments disclose memory cells composed of resistive memory elements that can be formed in integrated circuits such as programmable integrated circuits. The integrated circuits may be any suitable type of integrated circuit, such as microprocessors, application-specific integrated circuits, digital signal processors, memory circuits, or other integrated circuits. If desired, the integrated circuits may be programmable integrated circuits that contain programmable logic circuitry. The present invention will generally be described in the context of integrated circuits such as programmable logic device (PLD) integrated circuits as an example.

In the following description, for the purposes of explanation, numerous specific details are set forth in order to provide a thorough understanding of the present invention. It will be apparent, however, that the present invention may be practiced without these specific details. In other instances, well-known structures and devices are shown in block diagram form in order to avoid unnecessarily obscuring the present embodiments.

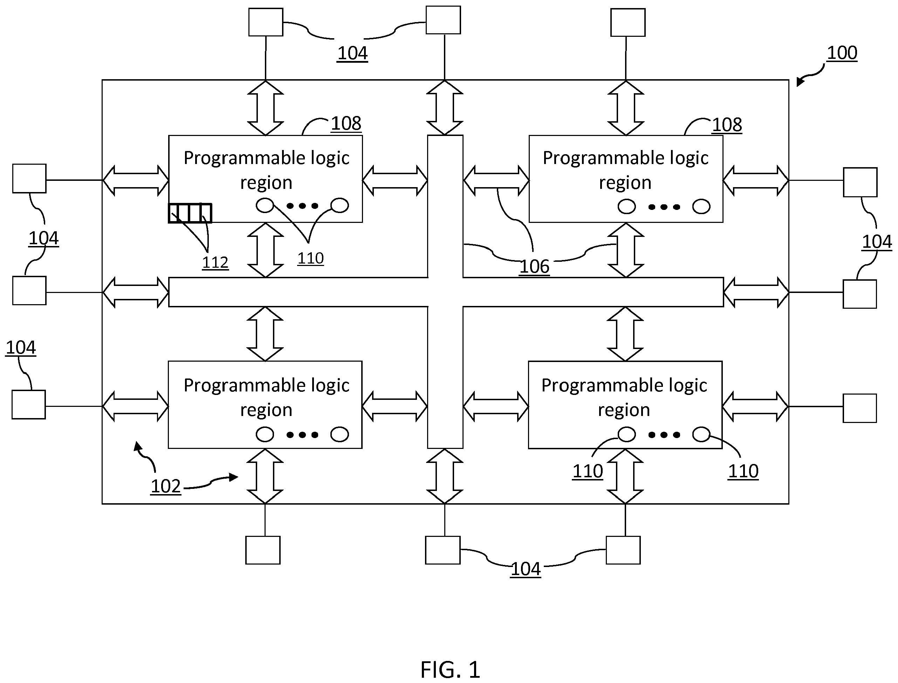

FIG. 1 illustrates a programmable logic device circuit. In FIG. 1, programmable logic device (PLD) circuit 100 may include input-output circuitry 102 for driving signals of device circuit 100 and for receiving signals from other devices via input-output pins 104. Interconnect circuit 106 may comprise resources such as global and local vertical and horizontal conductive lines and buses may be used to route signals on PLD circuit 100. Interconnect circuit 106 includes conductive lines and programmable connections between respective conductive lines and are therefore sometimes referred to as programmable interconnects.

PLD circuit 100 may include programmable logic 108 that can be configured to perform a custom logic function. Programmable logic 108 may include combinational and sequential logic circuitry. Interconnect circuit 106 may be considered to be a type of programmable logic 108.

PLD circuit 100 may also contain programmable memory array 110. Memory array 110 can be loaded with configuration data (also called programming data) using pins 104 and input-output circuitry 102. Once loaded, the memory elements may each provide a corresponding static control signal that controls the operation of an associated logic component in programmable logic 108. In a typical scenario, the outputs of the loaded memory array 110 is applied to the gates of metal-oxide-semiconductor transistors in programmable logic 108 to turn certain transistors on or off and thereby configure the logic in programmable logic 108 and routing paths. Programmable logic circuit elements that may be controlled in this way include pass transistors, parts of multiplexers (e.g., multiplexers used for forming routing paths in interconnect circuit 108), look-up tables, logic arrays, various logic gates, etc.

Memory array 110 may be implemented using any suitable volatile and/or non-volatile memory structures such as random-access-memory (RAM) cells, fuses, antifuses, programmable read-only-memory memory cells, mask-programmed and laser-programmed structures, resistive memory structures, combinations of these structures, etc. Because memory array 110 is loaded with configuration data during programming, memory array 110 is sometimes referred to as configuration memory, configuration RAM (CRAM), or programmable memory elements.

The circuitry of PLD circuit 100 may be organized using any suitable architecture. As an example, the logic of PLD circuit 100 may be organized in a series of rows and columns of larger programmable logic regions each of which contains multiple smaller logic regions. The smaller regions may be, for example, regions of logic that are sometimes referred to as logic elements (LEs), each containing a look-up table (LUT), one or more registers, and programmable multiplexer circuitry. The smaller regions may also be, for example, regions of logic that are sometimes referred to as adaptive logic modules (ALMs). Each adaptive logic module may include a pair of adders, a pair of associated registers and a look-up table or other block of shared combinational logic (as an example). The larger regions may be, for example, logic array blocks (LABs) containing multiple logic elements or multiple ALMs. In the example of FIG. 1, illustrative logic regions 112 (which may be, for example, LEs or ALMs) are shown in one of the larger regions of programmable logic 108 in FIG. 1 (which may be, for example, a logic array block). In a typical PLD circuit 100, there may be hundreds or thousands of smaller logic regions 112. Logic regions 112 that are shown in FIG. 1 are merely illustrative.

During device programming, configuration data is loaded into PLD circuit 100 that may configure the programmable logic regions 112 and programmable logic regions 108 so that their logic resources perform desired logic functions on their inputs and produce desired output signals. For example, CRAM cells are loaded with appropriate configuration data bits to configure adders and other circuits on device 100 to implement desired custom logic designs.

The resources of PLD circuit 100 such as programmable logic regions 108 may be interconnected by interconnect circuit 106. Interconnect circuit 106 generally includes vertical and horizontal conductors. These conductors may include global conductive lines that span substantially all of device 100, fractional lines such as half-lines or quarter lines that span part of PLD circuit 100, staggered lines of a particular length (e.g., sufficient to interconnect several logic array blocks or other such logic areas), smaller local lines, or any other suitable interconnection resource arrangement. If desired, the logic of PLD circuit 100 may be arranged in more levels or layers in which multiple large regions are interconnected to form still larger portions of logic. Still other device arrangements may use logic that is not arranged in rows and columns.

In addition to the relatively large blocks of programmable logic that are shown in FIG. 1, PLD circuit 100 generally also includes some programmable logic associated with the programmable interconnects, memory, and input-output circuitry on PLD circuit 100. For example, input-output circuitry 102 may contain programmable input and output buffers. Interconnect circuit 106 may be programmed to route signals to a desired destination.

Embodiments of the present invention relate to integrated circuit memory arrays 110 that are resistant to soft error upset events. The memory array 110 can be used in any suitable integrated circuits that use memory. These integrated circuits may be memory chips, digital signal processing circuits with memory arrays, microprocessors, application specific integrated circuits with memory arrays, programmable integrated circuits such as programmable logic device integrated circuits in which memory array 110 is used for configuration memory, or any other suitable integrated circuit.

On integrated circuits such as memory chips or other circuits in which memory is needed to store processing data, memory array 110 may be volatile memory elements (e.g., random-access memory cells such as static random-access memory cells), nonvolatile memory elements (e.g., relay devices, fuses, antifuses, electrically-programmable read-only memory elements, etc.), or other types of memory elements. In the context of programmable integrated circuits, memory array 110 can be used to store configuration data and are therefore sometimes referred to in this context as configuration memory cells.

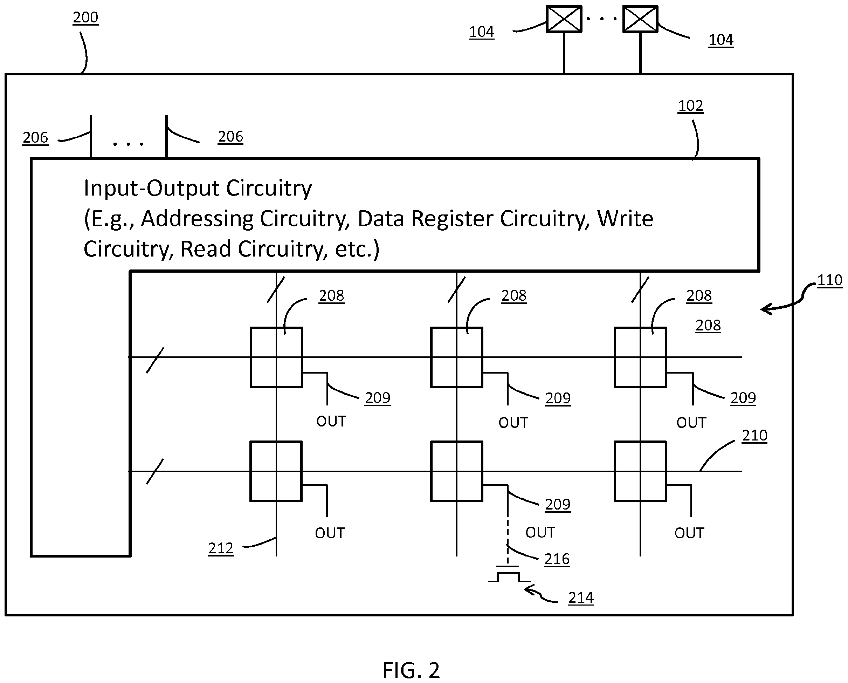

FIG. 2 shows an integrated circuit that may include memory array 110. Memory array 110 of FIG. 2 is comprised of memory cells 208 and for the purposes of illustrating clear examples, memory cells 208 forming memory array 110 will be discussed with reference to PLD circuit 100 of FIG. 1. Any suitable memory array architecture may be used for memory cells 208. One suitable arrangement is shown in FIG. 1. There are only two rows and three columns of memory cells 208 in the illustrative array of FIG. 1, but in general there may be hundreds or thousands of rows and columns in memory array 110. Memory array 110 may be one of a number of arrays on a given device 200, may be a subarray that is part of a larger array, or may be any other suitable group of memory cells 208.

Each memory array 110 may supply a corresponding output signal OUT at a corresponding output path 209. In configuration memory arrays, each signal OUT is a static output control signal that may be conveyed over a corresponding path 216 and may be used in configuring a corresponding transistor such as transistor 214 or other circuit element in an associated PLD circuit 100.

Integrated circuit 200 may have input-output circuitry 102 for supplying signals to memory array 110. Input-output circuitry 102 may receive power supply voltages, data, and other signals from external sources using pins 104 and from input-output circuitry 102 including paths such as paths 206. Input-output circuitry 102 may include circuitry such as addressing circuitry, data register circuitry, write circuitry, read circuitry, etc. Input-output circuitry 102 may use the power supply voltages supplied by pins 104 to produce desired time-varying and fixed signals on paths such as paths 210 and 212.

The signals that are supplied to memory array 110 may sometimes be collectively referred to as control signals. In particular contexts, some of these signals may be referred to as power signals, clear signals, data signals, address signals, etc. These different signal types are not mutually exclusive. For example, a clear signal for memory array 110 may serve as a type of control (address) signal that can be used to clear array 110. This clear signal may also serve as a type of power signal by powering inverter-like circuitry in cells 208. Likewise, because clearing operations serve to place logic zeros in memory cells 208, clear signals may serve as a type of data signal.

In general, there may be any suitable number of conductive lines associated with paths 210 and 212. For example, each row of memory array 110 may have associated address lines (e.g., a true address line and a complement address line) and associated read/write enable lines in a respective one of paths 210 (as examples). Each column of memory array 110 may have a respective path 212 that includes data lines. The terms "rows" and "columns" merely represent one way of referring to particular groups of cells 208 in memory array 110 and may sometimes be used interchangeably. If desired, other patterns of lines may be used in paths 210 and 212. For example, different numbers of power supply signals, data signals, and address signals may be used.

A clear signal may be routed to all of the memory cells 208 in memory array 110 simultaneously over a common clear line. The clear line may be oriented vertically so that there is one branch of the clear line in each path 212 or may be oriented horizontally so that there is one branch of the clear line in each path 210. The clear line need not be necessary.

Power can also be distributed in this type of global fashion. For example, a positive power supply voltage Vcc may be supplied in parallel to each cell 208 using a pattern of shared horizontal or vertical conductors. A ground voltage Vss may likewise be supplied in parallel to cells 208 using a pattern of shared horizontal or vertical lines. Control lines such as address lines and data lines are typically orthogonal to each other (e.g., address lines are vertical while data lines are horizontal or vice versa).

Positive power supply voltage Vcc may be provided over a positive power supply line. Ground voltage Vss may be provided over a ground power supply line. Any suitable values may be used for positive power supply voltage Vcc and ground voltage Vss. For example, positive power supply voltage Vcc may be 1.2 volts, 1.1 volts, 1.0 volts, 0.9 volts, less than 0.9 volts, or any other suitable voltage. Ground voltage Vss may be zero volts (as an example). In a typical arrangement, power supply voltages Vcc may be 1.0 volts, Vss may be zero volts, and the signal levels for address, data, and clear signals may range from zero volts (when low) to 1.0 volts (when high). Arrangements in which Vcc varies as a function of time, in which Vss is less than zero volts, and in which control signals are overdriven (i.e., in which control signals have signal strengths larger than Vcc-Vss) may also be used.

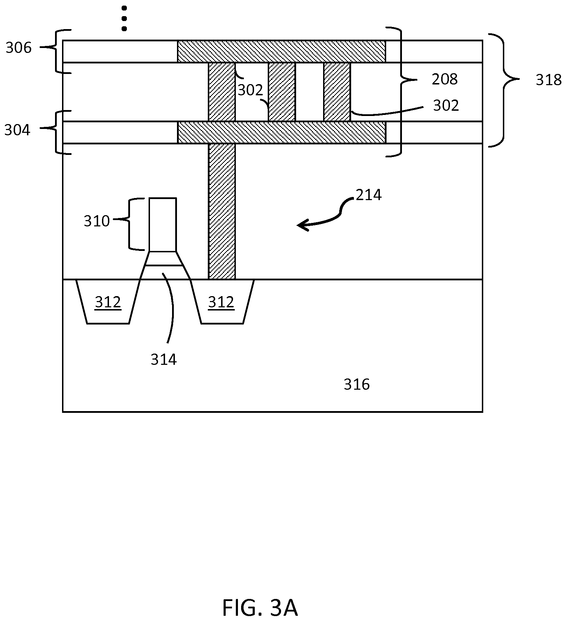

FIG. 3A illustrates a cross-sectional side view of an exemplary memory cell 208. For the purposes of illustrating clear examples, FIG. 3A will be discussed in reference to memory array 110 of FIG. 2. In an embodiment, the power supply lines discussed in FIG. 2 may be coupled to transistor 214. Transistor 214 may include source-drain regions (e.g., oxide definition regions) 312 separated by a channel region and a conductive gate structure 310 formed over the channel region. A layer of insulating material such as layer 314 of silicon oxide may be interposed between gate structure 310 and the surface of substrate 316 above the channel region. One of the source-drain terminals of transistor 214 may be coupled to time-varying power supply line through the contacts or contact holes containing resistive memory elements 302. A person skilled in the art will note that the number of resistive memory elements 302 (and by extension the number of contacts) is independent of the size of source-drain regions 312.

In an embodiment, the contacts or contact holes containing resistive memory elements 302 are long parallel structures that have widths that are at or greater than the minimum feature size for the manufacturing processes used to form the device. For example, current lithography and nano-imprint techniques may have minimum feature sizes that are on the order of 10 nanometers. Thus, if the contact holes containing resistive memory elements 302 were formed using a nano-imprint technique with a minimum feature size of 10 nanometers, the contact holes would have a width of 10 nanometers or more. Nano-imprinting is a method for fabricating nanometer scale patterns that is low cost, high throughput and high resolution. It creates patterns by mechanical deformation of the imprint resist. The imprint resist is typically a polymer formulation that is cured by heat or UV light during the imprinting. FIG. 3A illustrates contacts with a rectangular cross-section. In an embodiment, the contact holes may have a circular cross-section. In another embodiment, the edges of the metal layers are exposed to the contact holes.

Dielectric layer 318 may be formed over the surface of substrate 316. Dielectric layer 318 may include layers of silicon oxide or other dielectrics within which resistive memory elements 302 are formed. Dielectric layer 318 may include metal interconnect layers (sometimes referred to as metal layers or metal routing layers) and contacts for resistive memory elements 302. Conductive routing lines (sometimes referred to as metal interconnect paths) may be formed in the metal routing layers to electronically connect resistive memory elements 302 in parallel with each other. Contacts may also contain vertical conducting structures (e.g., conductive contacts such as tungsten contacts, copper contacts, aluminum contacts, or other metal contacts) configured to connect the conductive routing lines formed at opposing ends of each contact.

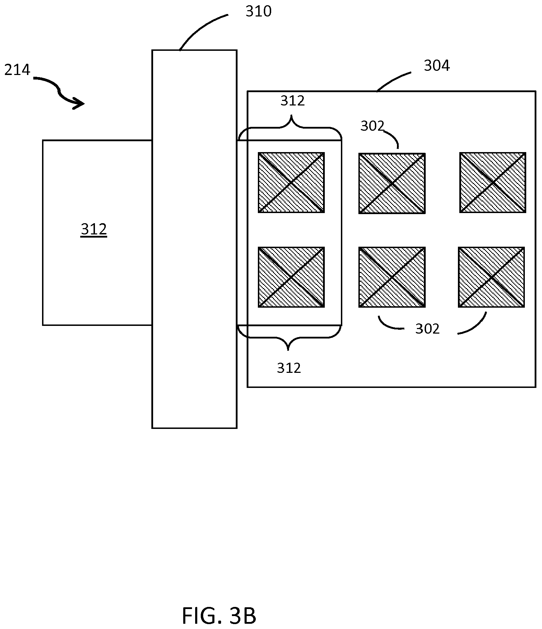

The metal routing layer closest to substrate 316 may be referred to as first metal routing layer 304. In an embodiment, there may be a number of successive metal routing layers. For example, first metal routing layer 304 represents a bottom layer in the dielectric stack, whereas a second metal routing layer 306 represents a top layer in the dielectric stack. Dielectric layer 318 may be configured in an alternating arrangement in which each adjacent pair of metal routing layers are separated by one or more resistive memory elements 302 formed in contacts. The implementation of the parallel connected resistive memory elements 302 is unaffected by either the size of the contact holes or the spacing between the metal layers. In the example of FIG.3, the time-varying power supply lines discussed above are formed in first metal routing layer 304. A person skilled in the art would recognize that the power supply lines might be formed in other metal routing layers, if desired. Similarly, resistive memory elements 302 may also be formed between different metal layers, if desired.

FIG. 3B illustrates a top view of an exemplary memory cell 208. Memory cell 208 in FIG. 3B includes six resistive memory elements 302 formed in dielectric layer 318 in contact with transistor 214 formed on substrate 316. Source-drain region 312 is separated by a channel region and a conductive gate structure 310 formed over the channel region. A person skilled in the art would note that the number of resistive memory elements 302 and the rectangular cross-section of the contacts varies among different implementations. Furthermore, the area of contact between transistor 214 and bottom metal layer 304 varies among implementations and is independent of the functioning of memory cell 208.

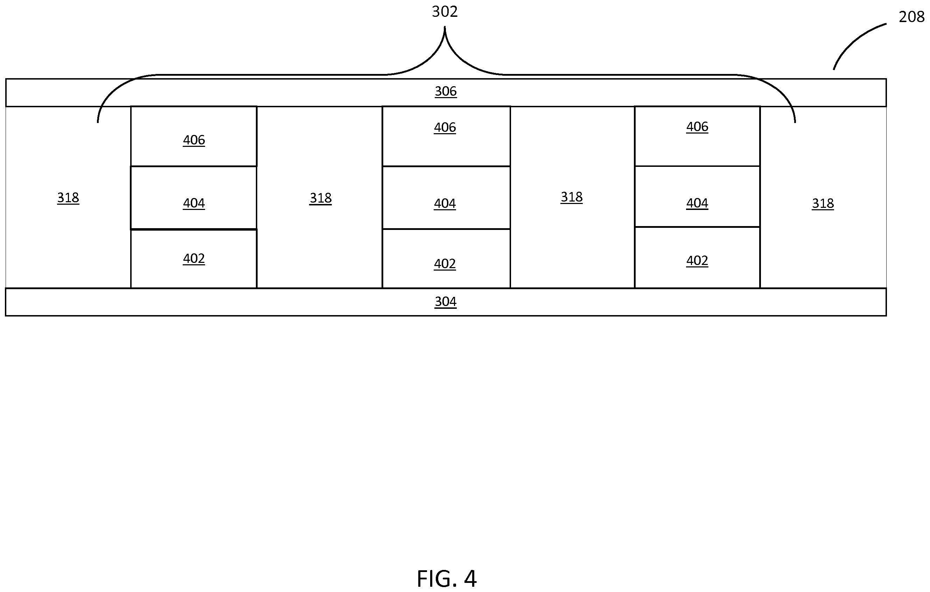

FIG. 4 illustrates a cross-sectional side view of an exemplary non-volatile resistive memory cell 208 in accordance with an embodiment of the present invention. For the purposes of illustrating clear examples, FIG. 4 will be discussed in reference to FIG. 3A and FIG. 3B. FIG. 4 illustrates a similar perspective of memory cell 208 as depicted in FIG. 3A and includes six resistive memory elements 302 (of which three are visible). However, a person having ordinary skill in the art will recognize that the number of resistive memory elements 302 will vary across implementations.

Resistive memory elements 302 include two metal layers and are electronically connected in parallel with each other. For example in FIG. 4, resistive memory elements 302 include the first metal layer 304 and the second metal layer 306. According to the present invention, resistive memory elements 302 include first metal layer 304, bottom electrodes 402, oxide layers 404, top electrodes 406, and second metal layer 306. In another embodiment, resistive memory elements 302 may have additional layers. For example, oxide layer 404 may include one or more layers of oxides of different materials. Similarly, resistive memory elements 302 may include one or more non-ohmic layers with a metal-insulator-metal (MIM) arrangement.

First and second metal layers 304 and 306 respectively may be formed from any suitable material, including conductive metals (such as aluminum, copper, platinum, or tungsten), conductive polymers, conductive carbon based materials (such as diamond film, graphene, carbon nanotubes), or other suitable materials. Typically, top and bottom electrodes 402 and 406 respectively are commonly composed of platinum, gold, silver, or aluminum. In an embodiment, wherein electrodes 402 and 406 are used as a barrier to prevent metal inter-diffusion, then a thin layer of metal, e.g. titanium nitride (TiN), may be formed on electrodes during fabrication. If a seed layer is additionally required, any number of electrically conductive materials can be used for on top of the thin layer of metal. For example, the seed layer could be a conductive perovskite, such as LaNiO3 or SrRuO3 on platinum, a conductive metal oxide, such as IrO2 on iridium or RuO2 on ruthenium, a noble metal such as platinum on TiN. A person skilled in the art will appreciate that the choice of electrode layers 402 and 406 in combination with the oxide layer 404 may affect the properties of resistive memory elements 302. As such, the memory function is realized either by oxide layer 404 properties or by the interface between electrodes 402 or 406 and the oxide layer 404.

Oxide layer 404 may be composed of perovskites (such as Sr(Zr)TiO₃), transition metal oxides (such as NiO or TiO₂), or and PCMO (Pr_{0.7}Ca_{0.3}MnO₃). In an embodiment, oxide layer 404 is composed of one or more layers of multi-resistive state materials. As an alternative to an oxide layer, a layer composed of chalcogenides (such as Ge₂Sb₂Te₅ or AgInSbTe) or solid-state electrolytes (such as GeS, GeSe, Cu₂S) could be used as layer 404. In another example, layer 404 may comprise an oxide of at least one element of a group of elements consisting of germanium, silicon, and selenium. A person skilled in the art will appreciate that, since resistive memory elements 302 function as programmable nonvolatile resistors, any material that uses trapped charges to modify or alter conductivity could be used in the contacts to form resistive memory elements 302.

For example, doping different materials (e.g., insulators, conductors, conductive oxides, and/or polymers) may create charge traps by substituting the dopant for crystalline elements and allow oxide layer 404 to function as a programmable nonvolatile resistor. Doping may also be used to create charge traps by interstitially introducing dopants into a crystalline structure. In addition, introducing separate physical clusters, or groups of atoms, into a crystalline structure may create charge traps as well. The resistance value of oxide layer 404 is dependent on its area and thickness as well as other properties, such as oxygen content, crystalline structure, and stoichiometry. Similarly, the voltage at which oxide layer 404 switches resistive states is also dependent upon the various properties of the material used to form oxide layer 404.

The contacts and the resistive memory elements are formed in a layer of inter-metal dielectric or dielectric layer 318. Dielectric layer 318 may be formed of boron and phosphorous doped silicon glass (BPSG), silicon dioxide (SiO₂), or silicon nitride (Si₃N₄).

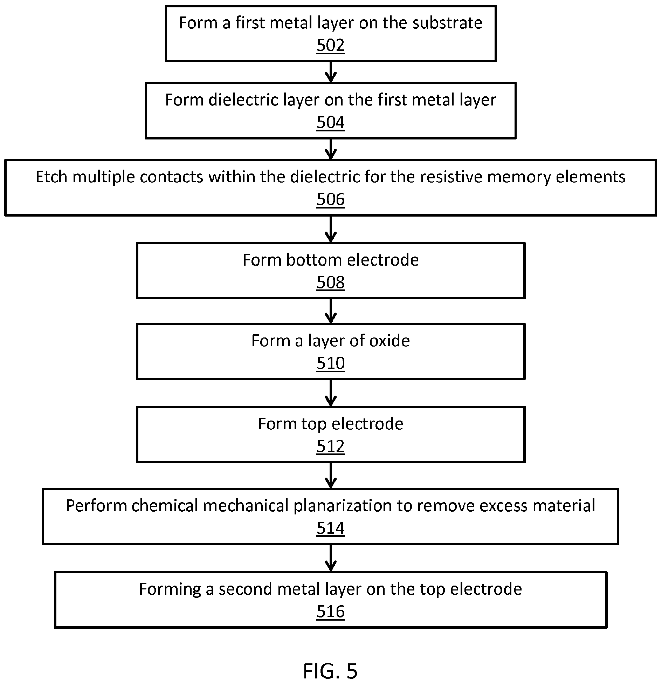

FIG. 5 illustrates an exemplary method of forming memory cell 208 in accordance with an embodiment of the present invention. For the purposes of illustrating clear examples, the method illustrated in FIG. 5 will be discussed in reference to memory cell 208 illustrated in FIGS. 3A, 3B, and 4. However, the same or a substantially similar method may be used for other implementations.

The fabrication process discussed in FIG. 5 may be preceded by front end of the line (FEOL) transistor formation on the circuit wafer. FEOL process FEOL contains all processes of semiconductor (for example complimentary metal-oxide semiconductor or CMOS) fabrication needed to form fully isolated semiconductor elements. The FEOL process may include selecting the type of wafer to be used, chemical-mechanical planarization (CMP) and cleaning of the wafer, shallow trench isolation (STI), well formation, gate module formation, and source and drain module formation. A person skilled in the art would appreciate that that each of the sub-processes of the FEOL process can be carried out using a wide variety of semiconductor fabrication techniques and methods.

Referring now to FIG. 5 again, at block 502, first metal layer 304 is formed on substrate 316. As discussed above, first metal layer 304 may be formed by depositing a suitable conductive metal for example copper or aluminum on the substrate. In another embodiment, the deposition of the metal layer is followed by forming conductive lines in first metal layer 304. In an embodiment, the deposition of conductive metal is followed by CMP to remove excess material. At block 504, dielectric layer 408 is formed on first metal layer 304. In an embodiment, dielectric layer 408 formed is an inter-metal dielectric. Dielectric layer 408 is formed by depositing a suitable insulator.

At block 506, a mask is applied to the wafer and the contact holes for resistive memory elements 302 are etched. In an embodiment, a photoresist or light-sensitive film is applied to the circuit wafer, giving it characteristics similar to a piece of photographic paper. A photo aligner aligns the wafer to the mask for etching contact holes for resistive memory elements 302 and then projects an intense light through the mask and through a series of reducing lenses, exposing the photoresist with the mask pattern. The exposed photoresist is then removed and baked to harden the remaining photoresist mask pattern. The wafer is then exposed to a chemical solution or plasma (gas discharge) so that areas not covered by the hardened photoresist are etched away. A person skilled in the art would appreciate that the contact holes for resistive memory elements 302 can be formed by utilizing many other techniques.

At block 508, resistive memory elements 302 are formed concurrently in the contact holes etched above. Bottom electrode 402 is formed in each of the contacts. At block 510, layer of oxide 404 is formed on bottom electrode 402. In an embodiment, forming layer of oxide 404 may include forming multiple layers of different oxides depending upon the fabrication specification. Layer of oxide 404 is the resistive memory material similar to the oxide layer described above. At block 512, top electrode 406 is formed on layer of oxide 404.

At block 514, chemical-mechanical planarization (CMP) is performed to remove access material deposited during the formation of memory cell 208. In an embodiment, CMP may also be performed following other deposition steps in the formation of memory cell 208. A person skilled in the art will appreciate that CMP may be performed via a variety of methods. At block 516, second metal layer 306 is formed on top electrodes 406 connecting the multiple resistive memory elements 302 in parallel.

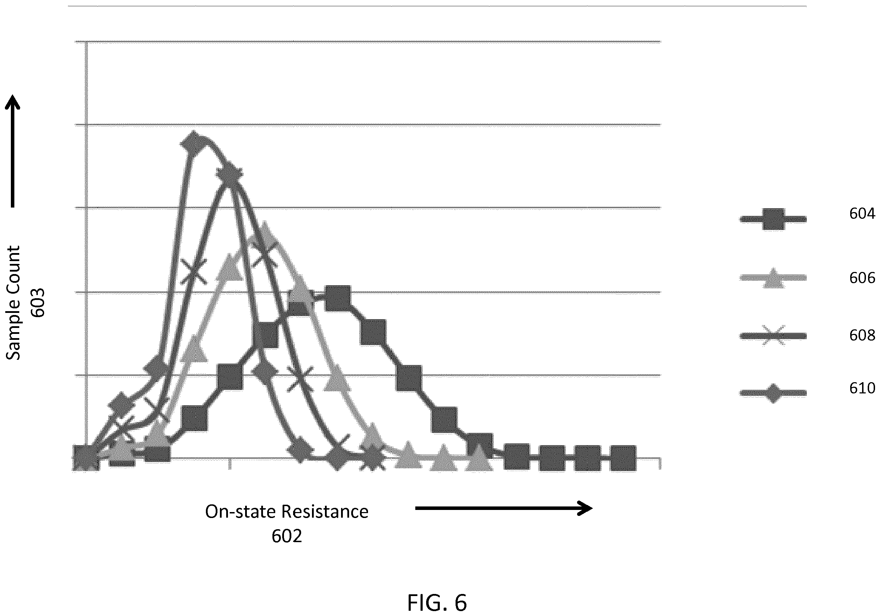

FIG. 6 illustrates an exemplary graphical representation of the relationship between the on-state or set resistance of a memory cell 208 and a number of non-volatile resistive memory elements 302 per memory cell in accordance with an embodiment of the present invention. For the purposes of illustrating clear examples, FIG. 6 will be discussed in reference to FIG. 4. Resistive memory elements 302 exhibit a non-volatile resistance value (a "state"). In some examples, resistive memory elements 302 can be used to store data, with the ON or low resistance state representing a digital 1 and an OFF or high resistance state representing a digital 0. In other implementations, resistive memory elements 302 may be part of multilevel cells that have more than two readable states.

Resistive memory elements 302 are programmed by applying a programming voltage (or "write voltage") across resistive memory elements 302 electronically connected in parallel to each other. Since, the resistive memory elements are electronically connected in parallel to each other, once the lowest resistance resistive memory element out of resistive memory elements 302 acquires a resistance value (maybe referred to as SET value), the voltage across the remainder of resistive memory elements collapses. Thus, the final resistance value will be always determined by the first programmed, lowest resistance value. The application of the programming voltage causes a nonvolatile change in the electrical resistance of the resistive memory element, thereby changing its state.

The state of the memory element can be read by applying a read voltage. The read voltage has a lower magnitude than the write voltage and does not disturb the state of the resistive memory element. The state can be determined by reading the amount of a current that passes through the resistive memory element when the read voltage is applied. For example, if a relatively large amount of current flows through the resistive memory element, it can be determined that the resistive memory element is in a low resistance state. If a relatively small amount of current flows through the resistive memory element, it can be determined that the memory element is in a high resistance state.

FIG. 6 illustrates the effects on the SET resistance of a memory cell 208 with different combinations of resistive memory elements 302 electronically connected in parallel. The graphical curves represented by different symbols 604, 606, 608, and 610, represent the on-state resistance distribution for a single resistor, a memory cell containing three resistive memory elements, a memory cell containing four resistive memory elements, and a memory cell containing 12 resistive memory elements, respectively. The axis labeled 602 represents the on-state or set resistance for 604, 606, 608, and 610 increasing from left to right. The axis labeled 603 represents the number of samples for 604, 606, 608, and 610 were tested against. As is depicted by the distribution in the graph, resistive memory elements 302 electronically connected in parallel with each other lead to a tighter range for the on-state resistance and a lower mean for the SET resistance. In other words, on-state resistance is lower and less variable when using memory cells with multiple resistive memory elements 302. A person skilled in the art would appreciate that this can be explained because memory cell 208 is always set to the resistance value of the resistive memory element with the lowest resistance.

Memory cell 208 described above can be incorporated in a variety of circuit architectures to replace existing memory cell structures. For example, memory cell 208 may be utilized in a crossbar memory array as described in FIG. 2. Similarly, a combination of two memory cells and a select transistor may be used to replace a six-transistor phase change random access memory (6T CRAM or 6T PCRAM).

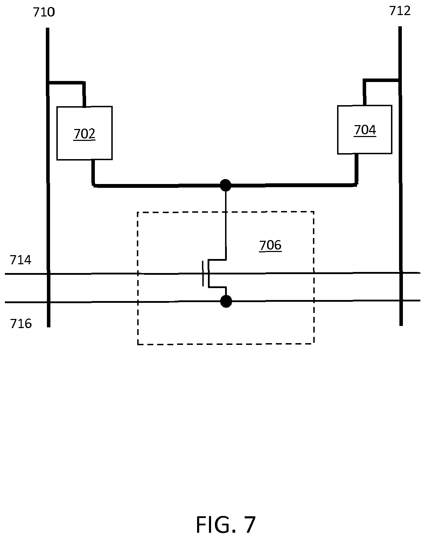

FIG. 7 illustrates an example integrated circuit incorporating two memory cells 702 and 704 in accordance with an embodiment of the present invention. For the purposes of illustrating clear examples, FIG. 7 will be discussed in reference to FIG. 3A, 3B, and 4.

Referring now to FIG. 7, two memory cells 702 and 704 may be referred to as left and right memory cells respectively. Left memory cell 702 and right memory cell 704 are coupled to a shared select transistor 706. In an embodiment, bit lines 710 and 712 may be referred to as left bit line (LBL) and right bit line (RBL) respectively. LBL 710 and RBL 712 may be connected to programming voltages (or write voltages). The source-drain terminals of select transistor 706 are connected to a row-based signal (RS) 716. RS 716 may be connected to programming voltages or ground. To write a logic "1" to the memory structure of FIG. 7, left memory cell 702 is set to a low-resistance state. First, word line 714 is asserted and RS 716 is connected to ground. Then a suitable voltage (V_{SET}) is applied to LBL 710 while RBL 712 is left floating. Select transistor 706 limits the current as left memory cell 702 changes from high-resistance to low-resistance state. Similarly, to write 0 to right memory cell 704, right memory cell 704 is set to low-resistance state by floating LBL 710 and applying V_{SET} voltage to RBL 712.

Once written, the memory structure of FIG. 7 must be erased and restored to a fresh state (where both left memory cell 702 and right memory cell 704 are in high-resistance states) before opposite logic states can be written to each memory cell. The process of resetting the memory structure of FIG. 7 includes resetting each of the memory cells 702 and 704. First, LBL 710 is connected to ground and RBL 712 is left floating. After asserting word line 714, a reset voltage (V_{RST}) is applied to RS 716. Thus, a reset current flows to left memory cell 702. Similarly, to reset right memory cell 704, RBL 712 is grounded and LBL 710 is left floating and the process described above is repeated.

Both memory cells 702 and 704 can be read to verify the memory structure's logic state. The read process is similar to the resetting process. A read voltage (V_{RD}) is applied to RS 716 such that V_{RD} < V_{RST} and the bit line associated with the memory cell to be read is selected. The selected bit line is then connected to a mirror based sense amplifier that detects the resistance of the memory cell connected with the selected bit line.

All optional features of the apparatus described above may also be implemented with respect to the method or process described herein. In the foregoing specification, embodiments of the invention have been described with reference to numerous specific details that may vary from implementation to implementation. The specification and drawings are, accordingly, to be regarded in an illustrative rather than a restrictive sense.

## Claims

1. A memory cell (208) comprising:
first and second metal layers (304, 306);
a dielectric layer (318) formed between the first and second metal layers (304, 306);
a first non-volatile resistive memory element (302); and
a second non-volatile resistive memory element (302) coupled in parallel to the first non-volatile resistive memory element;
wherein the first and second non-volatile resistive memory elements (302) are formed in first and second contact holes etched in the dielectric layer (318) and each comprise a layer of oxide (404),
**characterized in that**
each of the non-volatile resistive memory elements (302) comprises:
a bottom electrode (402) on the first metal layer (304); the layer of oxide (404) on the bottom electrode (402); and
a top electrode (406) on the layer of oxide (404),
**and in that** the second the top electrodes metal layer (306) is provided on (406).

2. The memory cell (208) as defined in claim 1, wherein the first and second non-volatile resistive memory elements (302) are configured to operating in first and second resistive states, and wherein each of the first and second resistive states represents a different data state.

3. The memory cell (208) as defined in claim 1 or 2, wherein the first and second non-volatile resistive memory elements (302) are connected in parallel (516) by a plurality of conductive lines formed in the first and second metal layers (304, 306).

4. The memory cell (208) as defined in any one of claims 1 to 3, wherein the respective layer of oxide (404) of the non-volatile resistive memory elements (302) comprises an oxide of at least one element of a group of elements consisting of germanium, silicon, and selenium.

5. An integrated circuit comprising:
a select transistor (706, 214);
a first memory cell (702, 208) and a second memory cell (704, 208), wherein each of the first memory cell and the second memory cell is a memory cell as defined in any one of claims 1 to 3,
wherein first and second non-resistive memory elements (302) are coupled to a source-drain region (312) of the select transistor.

6. The integrated circuit of claim 5, further comprising:
a first bit line (710) that is connected to the first memory cell (702, 208);
a second bit line (712) that is connected to the second memory cell (704, 208);
a row-based signal line (716) that is connected to an additional source-drain terminal of the select transistor (706, 214); and
a word line (714) that is connected to a gate terminal of the select transistor (706, 214).

7. A method for forming a memory cell (208) comprising:
forming an access transistor (214) in a substrate (316);
forming (502) a first metal layer (304) on the substrate;
depositing (504) an inter-metal dielectric layer (318) on the first metal layer (304);
etching (506) first and second contact holes in the inter-metal dielectric layer (318); and
forming first and second non-volatile resistive memory elements (302) in the first and second contact holes, respectively; and
forming (516) a second metal layer (306), wherein forming the first and second non-volatile resistive memory elements (302) comprises:
forming (508) first and second bottom electrodes (402) in the first and second contact holes;
depositing (510) first and second layers of oxide (404) on the first and second bottom electrodes; and
forming (512) first and second top electrodes (406) on the first and second layers of oxide;
and wherein forming the second metal layer comprises forming the second metal layer (306) on the first and second top electrodes.

8. The method as defined in claim 7, further comprising:
performing (514) a chemical-mechanical planarization on the first and second contact holes.

9. The method as defined in claim 7 or 8, wherein depositing the first and second layers of oxide further comprises:
depositing first and second layers of a first oxide (404) on the first and second bottom electrodes (402), respectively; and
depositing first and second layers of a second oxide (404) on the first and second layers of the first oxide (404), respectively.

10. The method as defined in any one of claims 7 to 9, wherein the first and second layers of oxide (404) comprise an oxide of at least one element of a group of elements consisting of germanium, silicon, and selenium.

11. The method as defined in any one of claims 7 to 10, wherein a cross-sectional shape of the first and second contact holes is determined according to a method of etching the first and second contact holes.

12. The method as defined in any one of claims 7 to 11, further comprising coupling the first and second non-volatile resistive memory elements (302) to a source-drain terminal (312) of the access transistor (214).

## Patentansprüche

1. Speicherzelle (208), die Folgendes umfasst:
eine erste und eine zweite Metallschicht (304, 306) ;
eine dielektrische Schicht (318), die zwischen der ersten und der zweiten Metallschicht (304, 306) gebildet ist;
ein erstes nichtflüchtiges resistives Speicherelement (302) und
ein zweites nichtflüchtiges resistives Speicherelement (302), das zu dem ersten nichtflüchtigen resistiven Speicherelement parallelgeschaltet ist; wobei
das erste und das zweite nichtflüchtige resistive Speicherelement (302) in einem ersten und einem zweiten Kontaktloch, die in die dielektrische Schicht (318) geätzt sind und jeweils eine Oxidschicht (404) umfassen, gebildet sind,
**dadurch gekennzeichnet, dass**
jedes der nichtflüchtigen resistiven Speicherelemente (302) Folgendes umfasst:
eine untere Elektrode (402) auf der ersten Metallschicht (304);
die Oxidschicht (404) auf der unteren Elektrode (402); und
eine obere Elektrode (406) auf der Oxidschicht (404), und dadurch, dass
die zweite Metallschicht (306) auf den oberen Elektroden (406) vorgesehen ist.

2. Speicherzelle (208) nach Anspruch 1, wobei das erste und das zweite nichtflüchtige resistive Speicherelement (302) konfiguriert sind, in einem ersten und einem zweiten resistiven Zustand zu arbeiten, und der erste und der zweite resistive Zustand einen jeweils unterschiedlichen Datenzustand repräsentieren.

3. Speicherzelle (208) nach Anspruch 1 oder 2, wobei das erste und das zweite nichtflüchtige resistive Speicherelement (302) durch mehrere Leiterbahnen, die in der ersten und der zweiten Metallschicht (304, 306) gebildet sind, parallelgeschaltet (516) sind.

4. Speicherzelle (208) nach einem der Ansprüche 1 bis 3, wobei die entsprechende Oxidschicht (404) der nichtflüchtigen resistiven Speicherelemente (302) ein Oxid mindestens eines Elements einer Gruppe von Elementen, die aus Germanium, Silizium und Selen besteht, umfasst.

5. Integrierte Schaltung, die Folgendes umfasst:
einen Wahltransistor (706, 214) und
eine erste Speicherzelle (702, 208) und eine zweite Speicherzelle (704, 208), wobei
sowohl die erste Speicherzelle als auch die zweite Speicherzelle eine Speicherzelle ist, die in einem der Ansprüche 1 bis 3 definiert ist, und
das erste und das zweite nicht resistive Speicherelement (302) an einen Source-Drain-Bereich (312) des Wahltransistors gekoppelt sind.

6. Integrierte Schaltung nach Anspruch 5, die ferner Folgendes umfasst:
eine erste Bitleitung (710), die mit der ersten Speicherzelle (702, 208) verbunden ist;
eine zweite Bitleitung (712), die mit der zweiten Speicherzelle (704, 208) verbunden ist;
eine zeilenbasierte Signalleitung (716), die mit einem zusätzlichen Source-Drain-Anschluss des Wahltransistors (706, 214) verbunden ist; und
eine Wortleitung (714), die mit einem Gate-Anschluss des Wahltransistors (706, 214) verbunden ist.

7. Verfahren zum Bilden einer Speicherzelle (208), das Folgendes umfasst:
Bilden eines Zugriffstransistors (214) in einem Substrat (316);
Bilden (502) einer ersten Metallschicht (304) auf dem Substrat;
Aufbringen (504) einer intermetallischen dielektrischen Schicht (318) auf der ersten Metallschicht (304);
Ätzen (506) eines ersten und eines zweiten Kontaktlochs in die intermetallische dielektrische Schicht (318); und
Bilden eines ersten und eines zweiten nichtflüchtigen resistiven Speicherelements (302) im ersten bzw. im zweiten Kontaktloch und
Bilden (516) einer zweiten Metallschicht (306), wobei
das Bilden des ersten und des zweiten nichtflüchtigen resistiven Speicherelements (302) Folgendes umfasst:
Bilden (508) einer ersten und einer zweiten unteren Elektrode (402) im ersten und im zweiten Kontaktloch;
Aufbringen (510) einer ersten und einer zweiten Oxidschicht (404) auf die erste und die zweite untere Elektrode und
Bilden (512) einer ersten und einer zweiten oberen Elektrode (406) auf der ersten und der zweiten Oxidschicht; und wobei
das Bilden der zweiten Metallschicht ein Bilden der zweiten Metallschicht (306) auf der ersten und der zweiten oberen Elektrode umfasst.

8. Verfahren nach Anspruch 7, das ferner Folgendes umfasst:
Durchführen (514) einer chemisch-mechanischen Planarisierung am ersten und am zweiten Kontaktloch.

9. Verfahren nach Anspruch 7 oder 8, wobei das Aufbringen der ersten und der zweiten Oxidschicht ferner Folgendes umfasst:
Aufbringen einer ersten und einer zweiten Schicht eines ersten Oxids (404) auf die erste bzw. die zweite untere Elektrode (402) und
Aufbringen einer ersten und einer zweiten Schicht eines zweiten Oxids (404) auf die erste bzw. die zweite Schicht des ersten Oxids (404).

10. Verfahren nach einem der Ansprüche 7 bis 9, wobei die erste und die zweite Oxidschicht (404) ein Oxid mindestens eines Elements einer Gruppe von Elementen, die aus Germanium, Silizium und Selen besteht, umfassen.

11. Verfahren nach einem der Ansprüche 7 bis 10, wobei eine Querschnittsform des ersten und des zweiten Kontaktlochs gemäß einem Ätzverfahren des ersten und des zweiten Kontaktlochs bestimmt wird.

12. Verfahren nach einem der Ansprüche 7 bis 11, das ferner ein Koppeln des ersten und des zweiten nichtflüchtigen resistiven Speicherelements (302) an einen Source-Drain-Anschluss (312) des Zugriffstransistors (214) umfasst.

## Revendications

1. Cellule de mémoire (208) comprenant :
une première et une deuxième couche métallique (304, 306) ;
une couche diélectrique (318) formée entre la première et la deuxième couche métallique (304, 306) ;
un premier élément de mémoire résistive non volatile (302) ; et
un deuxième élément de mémoire résistive non volatile (302) couplé en parallèle au premier élément de mémoire résistive non volatile ;
la première et la deuxième mémoire résistive non volatile (302) étant formées dans un premier et un deuxième trou de contact gravés dans la couche diélectrique (318) et comportant chacune une couche d'oxyde (404),
**caractérisée en ce que**
chacun des éléments de mémoire résistive non volatile (302) comprennent :
une électrode inférieure (402) sur la première couche métallique (304) ;
la couche d'oxyde (404) sur l'électrode inférieure (402) ; et
une électrode supérieure (406) sur la couche d'oxyde (404),
**et en ce que**
la deuxième couche métallique (306) est prévue sur les électrodes supérieures (406).

2. Cellule de mémoire (208) selon la revendication 1, dans laquelle les premier et deuxième éléments de mémoire résistive non volatile (302) sont configurés de façon à fonctionner dans un premier et un deuxième état résistif, et dans laquelle chacun du premier et du deuxième état résistif représente un état de données différent.

3. Cellule de mémoire (208) selon la revendication 1 ou 2, dans laquelle les premier et deuxième éléments de mémoire résistive non volatile (302) sont connectés en parallèle (516) par une pluralité de lignes conductrices formées dans la première et la deuxième couche métallique (304, 306).

4. Cellule de mémoire (208) selon l'une quelconque des revendications 1 à 3, dans laquelle la couche respective d'oxyde (404) des éléments de mémoire résistive non volatile (302) comprend un oxyde d'au moins un élément d'un groupe d'éléments consistant en le germanium, le silicium et le sélénium.

5. Circuit intégré comprenant :
un transistor de sélection (706, 214) ;
une première cellule de mémoire (702, 208) et
une deuxième cellule de mémoire (704, 208),
chacune de la première cellule de mémoire et de la deuxième cellule de mémoire étant une cellule de mémoire selon l'une quelconque des revendications 1 à 3,
le premier et le deuxième élément de mémoire non résistive (302) étant couplés à une région source-drain (312) du transistor de sélection.

6. Circuit intégré selon la revendication 5, comprenant en outre :
une première ligne de bit (710) qui est connectée à la première cellule de mémoire (702, 208) ;
une deuxième ligne de bit (712) qui est connectée à la deuxième cellule de mémoire (704, 208) ;
une ligne de signal basée sur rangées (716) qui est connectée à un terminal source-drain supplémentaire du transistor de sélection (706, 214) ; et
une ligne de mot (714) qui est connectée à un terminal grille du transistor de sélection (706, 214).

7. Procédé pour former une cellule de mémoire (208) comprenant :
la formation d'un transistor d'accès (214) dans un substrat (316) ;
la formation (502) d'une première couche métallique (304) sur le substrat ;
le dépôt (504) d'une couche diélectrique intermétallique (318) sur la première couche métallique (304) ;
la gravure (506) des premier et deuxième trous de contact dans la couche diélectrique intermétallique (318) ; et
la formation d'un premier et d'un deuxième élément de mémoire résistive non volatile (302) dans le premier et le deuxième trou de contact, respectivement ; et
la formation (516) d'une deuxième couche métallique (306),
la formation des premier et deuxième éléments de mémoire résistive non volatile (302) comprenant :
la formation (508) d'une première et d'une deuxième électrode (402) dans les premier et deuxième trous de contact ;
le dépôt (510) des première et deuxième couches d'oxyde (404) sur la première et la deuxième électrode inférieure ;
la formation (512) de la première et de la deuxième électrode supérieure (406) sur la première et la deuxième couche d'oxyde ;
et la formation de la deuxième couche métallique comprenant la formation de la deuxième couche métallique (306) sur la première et la deuxième électrode supérieure.

8. Procédé selon la revendication 7, comprenant en outre :
l'exécution (514) d'un aplanissement chimique-mécanique sur le premier et le deuxième trou de contact.

9. Procédé selon la revendication 7 ou 8, dans lequel le dépôt de la première et de la deuxième couche d'oxyde comprend en outre :
le dépôt d'une première et d'une deuxième couche d'un premier oxyde (404) sur la première et la deuxième électrode inférieure (402), respectivement ; et
le dépôt d'une première et d'une deuxième couche d'un deuxième oxyde (404) sur la première et la deuxième couche du premier oxyde (404), respectivement.

10. Procédé selon l'une quelconque des revendications 7 à 9, dans lequel la première et la deuxième couche d'oxyde (404) comprennent un oxyde d'au moins un élément d'un groupe d'éléments consistant en le germanium, le silicium et le sélénium.

11. Procédé selon l'une quelconque des revendications 7 à 10, dans lequel la forme de la section transversale du premier et du deuxième trou de contact est déterminée en fonction d'un procédé de gravure du premier et du deuxième trou de contact.

12. Procédé selon l'une quelconque des revendications 7 à 11, comprenant en outre le couplage des premier et deuxième éléments de mémoire résistive non volatile (302) à un terminal source-drain (312) du transistor d'accès (214).
